(19) Europäisches Patentamt
European Patent Office
Office européen des brevets

(11) **EP 2 252 900 B1**

(12) **FASCICULE DE BREVET EUROPEEN**

(45) Date de publication et mention de la délivrance du brevet:
**15.08.2018 Bulletin 2018/33**

(21) Numéro de dépôt: **09726557.3**

(22) Date de dépôt: **13.03.2009**

(51) Int Cl.:
***G01R 31/26*** *(2014.01)*

(86) Numéro de dépôt international:
**PCT/FR2009/050418**

(87) Numéro de publication internationale:
**WO 2009/122070 (08.10.2009 Gazette 2009/41)**

(54) **DISPOSITIF DE MODÉLISATION D'UN PANNEAU SOLAIRE À USAGE SPATIAL**

VORRICHTUNG ZUR MODELLIERUNG VON EINEM SOLARPANEL ZUR VERWENDUNG IM WELTRAUM

DEVICE FOR MODELING A SOLAR PANEL FOR USE IN SPACE

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **14.03.2008 FR 0851656**

(43) Date de publication de la demande:
**24.11.2010 Bulletin 2010/47**

(73) Titulaire: **Centre National d'Etudes Spatiales 75001 Paris (FR)**

(72) Inventeurs:
• **PAYAN, Denis**
**F-31320 Mervilla (FR)**
• **SARRAIL, Daniel**
**F-31320 Aureville (FR)**
• **INGUMBERT, Virginie**
**F-31450 Montesquieu-Lauraguais (FR)**

(74) Mandataire: **Gaillarde, Frédéric F. Ch. et al Cabinet Germain & Maureau 31-33, rue de la Baume 75008 Paris (FR)**

(56) Documents cités:
**EP-A- 0 938 141     GB-A- 2 224 391**

• **KAWASAKI ET AL: "Charge Neutralization via Arcing on a Large Solar Array in the GEO Plasma Environment" IEEE TRANSACTIONS ON PLASMA SCIENCE, IEEE SERVICE CENTER, PISCATAWAY, NJ, US, vol. 34, no. 5, 1 octobre 2006 (2006-10-01), pages 1979-1985, XP011149429 ISSN: 0093-3813**
• **BERTHOU ET AL: "Plasma ESD Qualification Test Procedure of Alcatel Alenia Space Solar Array" IEEE TRANSACTIONS ON PLASMA SCIENCE, IEEE SERVICE CENTER, PISCATAWAY, NJ, US, vol. 34, no. 5, 1 octobre 2006 (2006-10-01), pages 2004-2010, XP011149432 ISSN: 0093-3813**

**Description**

La présente invention concerne un dispositif de modélisation de la propagation d'une décharge électrostatique sur un panneau solaire à usage spatial de grandes dimensions à partir d'un coupon échantillon dudit panneau de petites dimensions, ledit coupon échantillon comportant au moins deux cellules photoélectriques séparées par un interstice, ledit dispositif permettant de simuler des décharges électrostatiques générées au niveau dudit interstice et se propageant au-delà des dimensions dudit coupon échantillon, afin de les analyser.

Les panneaux solaires mis en oeuvre sur les satellites placés en orbite sont détériorés par des décharges électrostatiques qui se produisent au niveau des cellules photoélectriques.

En particulier, de telles décharges sont générées dans les interstices séparant les cellules photoélectriques. Elles peuvent se propager de cellules en cellules et être à l'origine de nombreux dégâts sur les panneaux solaires qui peuvent avoir des conséquences fâcheuses pour le satellite.

On a donc cherché à étudier de telles décharges et leurs conséquences sur les panneaux solaires afin, par exemple, d'anticiper le comportement d'un panneau solaire ou afin de les prévenir.

Pour ce faire, comme décrit dans le document EP 0 938 141-A2, il est courant de tester un échantillon du panneau en le disposant dans une enceinte recréant l'environnement spatial, et d'analyser les décharges générées sur l'échantillon en faisant varier divers paramètres propres à l'environnement spatial ou au satellite alimenté en énergie par le panneau solaire.

On connaît également du document « Charge neutralization via arcing on a large solar array in the GEO plasma environment», IEEE Transactions on Plasma Science, Vol. 34, No. 5, Octobre 2006, un système de modélisation comprenant un coupon de panneau constitué de cellules photoélectriques montées sur une structure en nid d'abeilles, réalisée en aluminium et recouverte d'une feuille de polyimide.

De tels échantillons sont toutefois très onéreux et les expérimentations faites avec eux sont ainsi limitées en nombre.

Pour cette raison, la taille des échantillons testés a été diminuée.

Il s'agissait également de pouvoir disposer d'échantillons représentatifs d'un panneau complet dont la surface est généralement comprise entre **1** et 10m$^2$, de tels échantillons devant présenter une taille suffisamment petite pour être disposés dans des caissons à vide.

A cause de cette mesure de restriction de taille, le nombre de cellules solaires testées n'est plus assez important pour simuler correctement le comportement du panneau en orbite, ainsi les résultats obtenus ne sont plus représentatifs de la réalité. En effet, la partie de la décharge électrostatique (appelée communément « flash-over ») qui se propage à la surface du panneau en neutralisant la charge différentielle sur une surface de plusieurs mètres carrés (entre le panneau lui-même et les filtres de protection des cellules solaires) ne peut être représentée sur un échantillon de petite taille ou coupon.

A l'origine de l'invention, on a donc cherché à réaliser un dispositif qui permettrait de modéliser la décharge électrostatique qui aurait lieu sur un panneau de grande taille, c'est-à-dire pouvant atteindre plusieurs dizaines de mètres d'envergure, à partir d'un échantillon de taille plus petite, c'est-à-dire présentant des dimensions de quelques dizaines de centimètres, tout au plus 30 ou 40 cm de longueur.

Le dispositif selon l'invention permet d'atteindre cet objectif.

Pour ce faire, le dispositif selon l'invention est du type précité, c'est-à-dire de modélisation de la propagation d'une décharge électrostatique sur un panneau solaire à usage spatial de grandes dimensions, le dispositif comportant

- un coupon échantillon du panneau comportant au moins une cellule photoélectrique,
- et une unité de stockage électrostatique comportant une feuille métallique recouverte au moins partiellement d'un matériau diélectrique, l'unité de stockage présentant une ouverture traversante dans laquelle est disposé le coupon échantillon.

La feuille du dispositif permet de modéliser des cellules photoélectriques voisines aux cellules photoélectriques du coupon échantillon et le matériau diélectrique permet de modéliser les plaques de verre recouvrant les cellules photoélectriques. Ainsi réalisé, le dispositif permet de simuler et d'analyser des décharges électrostatiques qui sont générées notamment dans ledit interstice du coupon échantillon et qui se propagent au-delà du coupon échantillon.

De manière générale, le dispositif selon l'invention permet de simuler des décharges électrostatiques et d'étudier leur comportement sur une surface de panneau modélisée de dimensions suffisantes pour assimiler ces comportements à des comportements de décharges électrostatiques se produisant réellement sur des panneaux solaires mis en oeuvre dans un environnement spatial.

Ainsi réalisé, le dispositif constitue une modélisation de panneau solaire dont on peut choisir la taille et qui est bien moins onéreuse que le panneau solaire réel entier comportant uniquement des cellules photoélectriques, la taille choisie du panneau modélisé étant toutefois limitée par les dimensions internes d'une l'enceinte dans laquelle est recréé un environnement spatial, comme il sera vu par la suite.

Suivant un mode de réalisation, le coupon échantillon comporte au moins deux cellules photoélectriques séparées par un interstice.

Ce mode de réalisation permet d'obtenir un maximum de décharges électrostatiques lorsque le dispositif de modélisation est disposé dans un environnement simulant l'environnement spatial. Il a en effet été démontré qu'une majorité des décharges électrostatiques dangereuses prenaient naissance dans les interstices entre les cellules photoélectriques.

Suivant une variante de réalisation, l'ouverture ménagée dans ladite unité de stockage est sensiblement de la taille dudit coupon échantillon, et le coupon est fixé à l'unité de stockage par sa périphérie au moyen d'un matériau de fixation diélectrique. De cette manière, les moyens de fixation du coupon sur l'unité de stockage assurent une continuité dans la surface diélectrique et empêchent la formation de décharges électrostatiques qui pourraient fausser les résultats. La continuité des parties métalliques du simulateur et de l'échantillon permet également la propagation des courants de retour.

Suivant un mode de réalisation où l'unité de stockage est réalisée souple, le dispositif peut tapisser les parois d'une enceinte dans laquelle l'environnement spatial est simulé, ce qui permet de modéliser plusieurs mètres carrés de panneau.

En particulier, un tel mode de réalisation souple permet de disposer l'unité de stockage dans le caisson sur sa paroi interne, dont la surface est voisine de la surface totale d'un panneau solaire réel.

Suivant les caractéristiques du panneau solaire à tester, le matériau diélectrique est choisi en fonction de ses caractéristiques (épaisseur, constante diélectrique, surface...).

En particulier, suivant un mode de réalisation qui sera décrit et illustré par la suite, on peut prévoir que ledit matériau diélectrique soit un film de polyimide (polymère à base d'imide) connu sous le nom commercial de Kapton® ou Upilex®..

L'épaisseur du film de Kapton® peut être avantageusement inférieure à 500 $\mu$m, notamment d'épaisseur sensiblement égale à celle des feuilles de Kapton® disposées sous les cellules photoélectriques dans les panneaux solaires.

Le matériau de fixation du coupon échantillon sur l'unité de stockage peut également être réalisé en Kapon®, sous forme de bandes adhésives ou de film adhésif ou que l'on colle sur un support conducteur ou que l'on achète souple et directement métallisé en face arrière.

Suivant un autre mode de réalisation, on peut prévoir de réaliser le matériau diélectrique à partir de plaques de verre de dimensions identiques à celles desdites cellules du coupon échantillon, lesdites plaques étant disposées côte à côte et régulièrement réparties sur toute la surface de la feuille métallique.

On peut également prévoir de réaliser la feuille métallique en alliage d'aluminium pour sa légèreté et sa flexibilité.

La feuille métallique de l'unité de stockage et un support du coupon échantillon sont notamment reliés par une liaison de masse. Ainsi, l'unité de stockage se trouve au même potentiel que celui du coupon échantillon et permet la propagation des décharges électriques se produisant au niveau du coupon, dans un interstice.

L'invention vise également un système pour simuler des décharges électrostatiques sur un panneau solaire de grandes dimensions à usage spatial, à partir d'un dispositif de modélisation tel que défini ci-dessus.

L'invention sera mieux comprise à la lumière des modes de réalisations qui vont maintenant être décrits, en faisant référence aux figures annexées parmi lesquelles :

- la figure 1 est une représentation schématique d'un système selon l'invention permettant de simuler des décharges électrostatiques sur un dispositif selon l'invention, modélisant un panneau solaire de grandes dimensions à partir d'un coupon échantillon de plus petites dimensions ;
- la figure 2 est une vue en perspective partielle d'une enceinte comportant un élément support mobile sur lequel est disposé un coupon échantillon d'un panneau solaire, ainsi qu'une plaque métallique rigide présentant une ouverture centrale dans laquelle est inséré ledit coupon échantillon ;
- la figure 3 est une vue de dessus représentant partiellement un dispositif selon l'invention ;
- la figure 4 est une vue de dessus représentant entièrement le dispositif de la figure 4 ;
- la figure 5 est une vue de dessus d'un dispositif selon l'invention selon un second mode de réalisation ;
- la figure 6 est une vue en coupe d'un dispositif selon l'invention suivant un troisième mode de réalisation ;
- et la figure 7 est une vue en perspective partielle d'une enceinte dans laquelle est placé un dispositif de modélisation suivant un quatrième mode de réalisation.

Afin de mieux comprendre l'invention et ses effets avantageux, on s'intéressera dans un premier temps à un système selon l'invention pris dans sa globalité, permettant la simulation de décharges électrostatiques à partir d'un coupon échantillon d'un panneau solaire.

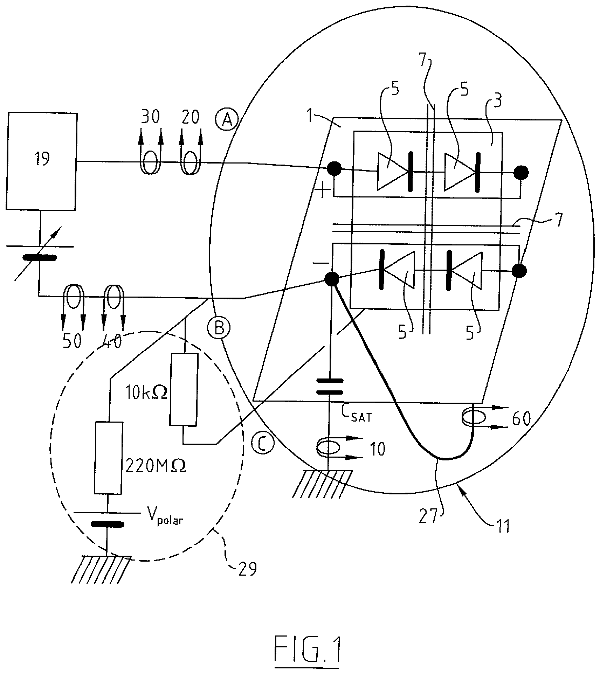

Le système selon l'invention schématisé sur la figure 1 permet de recréer des décharges électrostatiques qui se produisent sur un panneau solaire et, ainsi, de simuler la manière dont un panneau peut se décharger afin d'en étudier les effets notamment sur les cellules photoélectriques du panneau.

Le système selon l'invention comporte un dispositif 1 qui modélise un panneau solaire à partir d'un coupon échantillon 3 de ce panneau, le coupon 3 présentant des dimensions beaucoup plus petites que celles du panneau, de l'ordre de 1/12 par exemple.

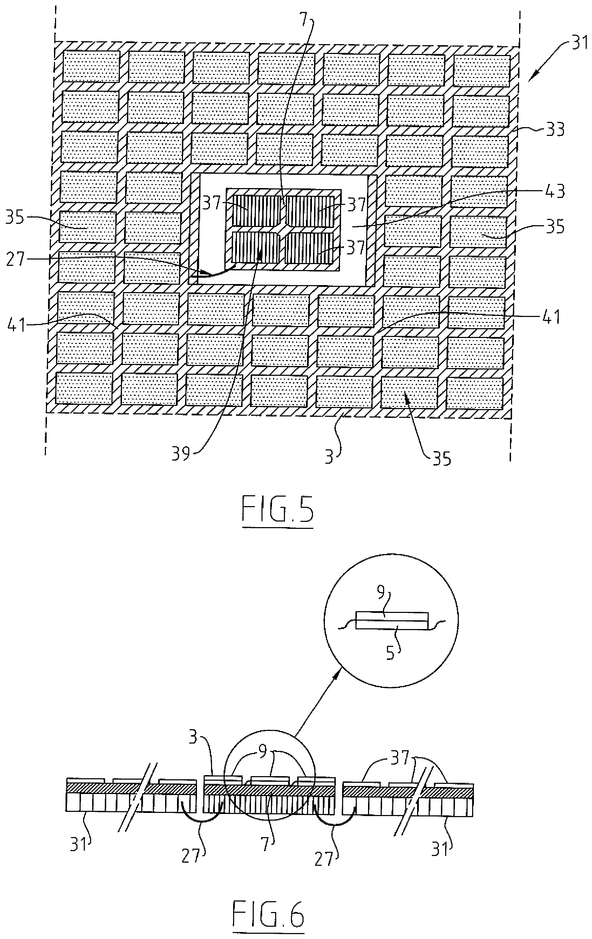

Le coupon 3 comporte au moins deux cellules photoélectriques 5 séparées par un interstice 7 (figure 6) et recouvertes par une plaque de verre 9 de mêmes dimensions.

La présence d'un interstice 7 entre deux cellules 5 est indispensable à la génération d'une décharge électrostatique. Il a en effet été démontré que les décharges électrostatiques dangereuses prenaient naissance pour une majorité de cas dans un interstice entre deux cellules.

Le dispositif de modélisation sera décrit plus en détails par la suite.

Les cellules photoélectriques 5 sont représentées par des diodes sur la figure 1.

Le dispositif de modélisation 1 est illustré schématiquement par un parallélogramme comportant le coupon 3, disposé dans l'enceinte 11 d'un caisson de simulation 12 d'environnement spatial.

Le caisson est de forme cylindrique. Il présente une longueur sensiblement égale à 3 m et un diamètre sensiblement égal à 1,85 m.

Il devra être entendu que l'invention n'est pas limitée à une mise en oeuvre spécifique dans le caisson présentement décrit, et qu'elle s'étend à une mise en oeuvre dans des caissons de tailles différentes.

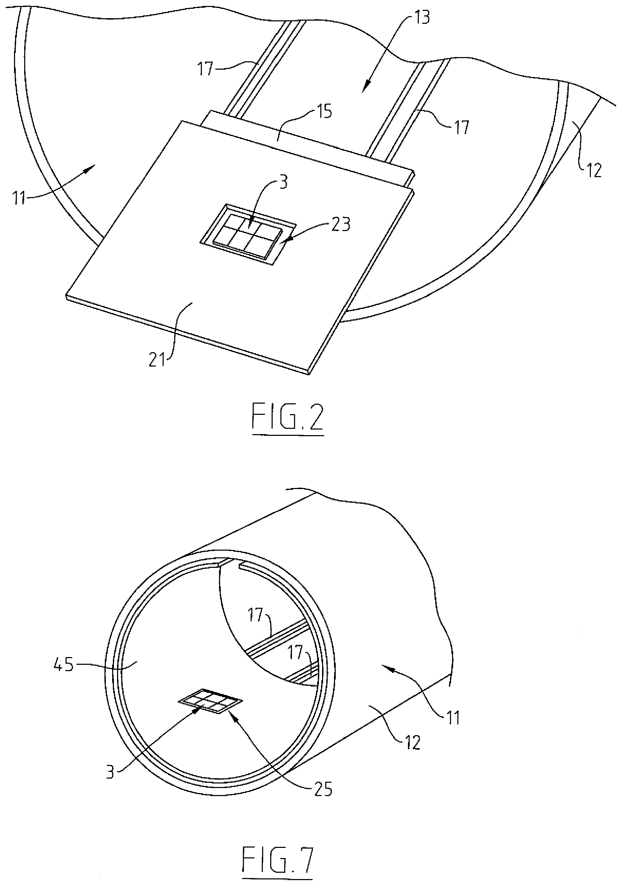

En particulier, le caisson de simulation comporte un fond mobile 13 illustré sur la figure 2 en particulier, équipé d'un plateau 15 visant à supporter le dispositif de modélisation 1 selon l'invention.

Le plateau 15 est monté mobile en déplacement sur des rails 17 parallèles à l'axe du caisson 12 de façon à pouvoir aisément manipuler le dispositif de modélisation 1, notamment pour le mettre en place dans le caisson 12 ou le retirer du caisson 12.

Le caisson est équipé de moyens permettant de simuler l'environnement spatial dans l'enceinte 11. Dans cet objectif, le caisson comporte une pompe permettant un pompage cryogénique de fort débit (12 000 l/s pour l'argon) assurant l'obtention d'un vide jusqu'à environ $10^{-8}$ hPa.

Le caisson comporte également une source à plasma de synthèse pour simuler l'environnement spatial pour des orbites basses, de sorte que la densité d'ions au centre de l'enceinte 11 varie entre $10^4$ et $10^6$ ions/cm$^3$. Un exemple de source qui est connue de l'homme du métier est une source KAUFFMAN.

Un canon à électrons est implanté sur le corps du caisson et permet d'obtenir un faisceau d'électrons d'énergie variant de quelques kiloélectronvolts à trente-cinq kiloélectronvolts avec une densité disponible sur un plateau horizontal comprise entre quelques picoampères par centimètre carré et le nanoampère par centimètre carré.

Une ou plusieurs microcaméras sont positionnées à l'intérieur de l'enceinte et sont destinées à acquérir, à l'aide d'un stockeur d'images numériques, les signaux lumineux produits lors des décharges électrostatiques.

Un jeu de capteurs et des sondes de courant actives (ou passives) 10, 20, 30, 40, 50 et 60 reliées à des oscilloscopes numériques complètent l'équipement et un ordinateur assure la saisie des données lors des expériences.

Les références A, B et C schématisent des traversées de cloison haute tension et assurent la liaison électrique entre le coupon 3 et les alimentations extérieures au caisson.

Les oscilloscopes, les caméras, les capteurs, le stockeur d'image, le canon à électrons, la source à plasma et la pompe n'ont pas été représentés sur les figures pour en simplifier la lecture.

De façon connue en soi, on prévoit que chaque oscilloscope soit réglé sur une base de temps différente afin d'être toujours en mesure de déterminer la durée d'un arc électrique initié par une décharge électrostatique.

Comme on le voit sur la figure 1, le montage électrique du système comporte un dispositif d'alimentation en tension 29, constitué par une alimentation haute tension qui assure la polarisation du coupon échantillon 3 à travers une résistance de découplage de 220 MΩ (Mégaohms). La tension dans l'interstice 7 (illustrée schématiquement par des trais pointillés) entre deux cellules photoélectriques 5 du coupon 3 est imposée par une source de tension de 60 V. Ce sont les caractéristiques du générateur solaire qui imposent la tension d'essai. On peut très bien avoir 30Volts comme 120volts aujourd'hui. Envisager 300Volts dans quelques années n'est pas déraisonnable, limitée en courant à une valeur préréglée très légèrement supérieure à la valeur du courant d'arc désirée.

Une source de tension permet de polariser la résistance de 10 kΩ, ainsi que le coupon à une valeur de tension proche de - 5000 V

La résistance de 10 kΩ existant quasiment toujours sur les satellites entre la structure du panneau solaire et la structure du satellite, elle est ainsi reprise pour réaliser les essais.

Un simulateur de générateur solaire 19 (« Solar Array Simulator », encore appelé SAS) relié au coupon 3 fixe ou impose le courant d'arc maximum. Il est constitué d'un composant électronique rapide écrêtant le courant disponible à la valeur préréglée.

Le SAS 19 alimente ainsi en courant le coupon 3.

Une capacité $C_{sat}$ de 330 pF est reliée au coupon 3 et modélise la capacité absolue du satellite en orbite. Cette

capacité $C_{sat}$ est placée sous vide dans l'enceinte pour s'approcher des conditions réelles dans lesquelles les décharges électrostatiques se produisent, ainsi que la sonde 10 de courant actif qui permet la lecture des décharges du type « blow off », c'est-à-dire la décharge électrostatique du satellite modélisé par la capacité $C_{sat}$.

Un propulseur ionique peut être monté dans l'axe de l'enceinte 11, à la place de la source KAUFFMAN. Ses effets peuvent ainsi être évalués sur différents éléments sensibles, et notamment le dispositif de modélisation 1 selon l'invention qui va maintenant être présenté en faisant référence aux figures 2 à 7.

On s'intéressera dans un premier temps au mode de réalisation illustré sur les figures 2 à 4, et dans un second temps aux modes de réalisations qui sont illustrés sur les figures 5 à 7.

Le dispositif de modélisation comporte une unité de stockage électrostatique comportant une feuille métallique 21 montrée en figure 2.

Dans le cadre de ce mode de réalisation, la feuille métallique 21 est réalisée rigide. Il doit être toutefois compris que la feuille métallique pourrait être réalisée souple sans sortir du cadre de l'invention, conformément à l'exemple illustré sur la figure 7.

La feuille métallique 21 est de forme carrée, et présente au voisinage de son centre une ouverture 23 de forme complémentaire à la forme périphérique du coupon 3. Il doit être toutefois compris que l'ouverture pourrait être non complémentaire sans sortir du cadre de l'invention, pour cela il suffit qu'elle ne perturbe ni l'établissement, ni la propagation de la décharge électrostatique.

Ainsi, comme le montre la figure 2, le coupon 3 s'insère dans l'ouverture 23 de la feuille métallique 21.

La feuille métallique 21 est ici réalisée en alliage d'aluminium. Il doit être toutefois compris que la feuille métallique pourrait être réalisée dans n'importe quel matériau conducteur ou ayant la même conductivité que la structure du panneau solaire que l'on souhaite tester

La longueur du côté de la feuille métallique 21 a été calculée pour que cette dernière repose sur le plateau support 15 dans l'enceinte 11 du caisson cylindrique.

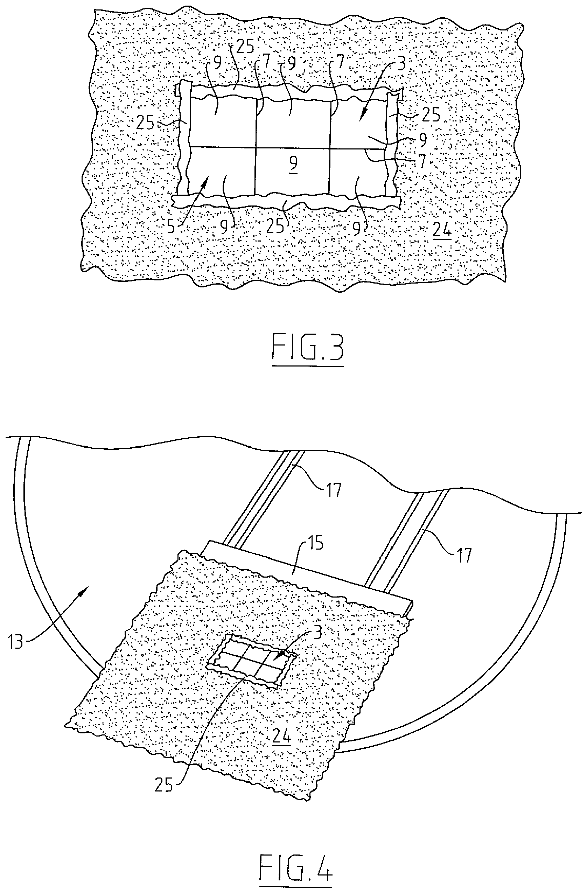

La feuille métallique 21 est recouverte entièrement d'un matériau diélectrique 24, comme le montrent les figures 3 et 4.

Suivant le mode de réalisation illustré sur les figures 3 et 4, le matériau diélectrique 24 est ici réalisé en un polymère de polyimide, commercialisé sous le nom de Kapton. Il doit être toutefois compris que le diélectrique pourrait être réalisé différemment (compatible en dégazage avec le vide) à condition de posséder des propriétés de stockage de charge (sa capacité rapportée à une surface de 1 cm$^2$) identique aux verres de protection des cellules solaires à tester.

Comme on peut le voir sur les figures 3 et 4, le coupon échantillon 3 est fixé à ladite unité de stockage, c'est-à-dire à la feuille d'aluminium recouverte de Kapton, par des bandes adhésives 25.

Les bandes adhésives 25 sont réalisées dans un matériau diélectrique. Dans l'exemple illustré, les bandes adhésives 25 sont réalisées en Kapton, et recouvrent partiellement la couche 24 de Kapton et les plaques de verre 9 des cellules photoélectriques 5.

Ainsi, le montage obtenu ne présente aucune interface métal/diélectrique qui pourrait être à l'origine d'une décharge électrostatique. Une telle décharge fausserait les résultats des expériences de simulation, car elle n'aurait pas été générée dans des conditions réelles sur un panneau solaire de grandes dimensions. La continuité diélectrique permettant d'assurer la propagation de la décharge à la surface dudit diélectrique.

Afin de simuler les décharges électrostatiques qui se produisent sur un panneau solaire, il convient de placer le dispositif de modélisation 1 dans un environnement similaire à l'environnement spatial et dans des conditions analogues à celles dans lesquelles on observe un tel phénomène de décharge.

Cet environnement peut être obtenu de deux façons différentes dans le cadre du présent exemple de réalisation et de mise en oeuvre :

- en polarisant les échantillons à de forts potentiels négatifs (autour de -5kVolts), la charge des verres pouvant être obtenue selon le principe de l'émission secondaire électronique sur le verre à l'aide d'un canon à électron de basse énergie (c'est un principe connu), et le niveau de vide dans le caisson devant être compatible avec les tensions appliquées,
- en introduisant un plasma dans l'enceinte, les polarisations étant alors nécessairement plus faibles. On compense alors le manque d'énergie stockée dans le simulateur en augmentant la capacité du simulateur par choix d'un diélectrique adapté à forte permittivité ou en diminuant son épaisseur, ou les deux si nécessaire.

On s'intéresse en particulier ci-après à la polarisation des échantillons.

Pour ce faire, on place sous tension le coupon échantillon 3 et l'unité de stockage reliés entre eux par une liaison de masse 27 (voir figures 1 et 5) au moyen du dispositif 29 décrit précédemment.

En polarisant le coupon par application d'un dispositif d'irradiation électronique de basse énergie ou d'un dispositif neutralisant par plasma, on recrée une différence de potentiel entre les verres 9 recouvrant les cellules photo-toélectriques (ou le matériau diélectrique de recouvrement 24 de l'unité de stockage) et la structure modélisée du panneau solaire, de façon à permettre la décharge électrostatique.

Une telle différence de potentiel est en effet une des causes des décharges électrostatiques qui se produisent dans l'espace : les verres des cellules photoélectriques se chargent positivement alors que le potentiel du satellite n'évolue pas. De ce fait, une différence de potentiel se crée et des décharges électrostatiques se produisent afin de rétablir un certain équilibre électrostatique par neutralisation brusque des potentiels différentiels.

On comprend ainsi comment le dispositif de modélisation et le système de simulation selon l'invention permettent de recréer des décharges électrostatiques semblables à celles qui se produisent réellement dans l'espace, et d'étudier les conséquences de telles décharges sur de grandes surfaces de panneaux solaires.

Les figures 5 et 6 illustrent deux autres modes de réalisation.

La figure 5 montre un dispositif de modélisation dont l'unité de stockage 31 comporte une feuille métallique 33, réalisée par exemple en alliage d'aluminium, sur laquelle sont disposées des plaques de verre 35 dont les dimensions et la forme sont sensiblement identiques à celles des plaques de verre 37 recouvrant les cellules photoélectriques 39 du coupon 3. Il doit être toutefois compris que la couche diélectrique n'a pas besoin d'être continue pour assurer la propagation de la décharge électrostatique à sa surface, sans sortir du cadre de l'invention. Elle peut-être constitué d'une multitude d'échantillons diélectriques de tailles différentes, voire de natures différentes.

Par ailleurs, la feuille métallique constituant l'unité de stockage n'est pas forcément réalisée d'un seul tenant , mais peut être le résultat de plusieurs feuilles ou bandes métalliques reliées ensemble. En introduisant une sonde de courant dans les différents liens électriques, on peut mesurer la propagation du phénomène de « Fash over » et déterminer la zone concernée par la décharge.

L'unité de stockage 31 présente ainsi des interstices 41 entre les plaques de verre 35 susceptibles de constituer des sites de génération d'une décharge électrostatique.

Le coupon 3 est disposé au centre d'une ouverture 43 traversante réalisée dans la feuille métallique 33.

L'ouverture 43 présente des dimensions supérieures à celle du coupon 3, de sorte que les bords du coupon ne soient pas en contact avec les bords de l'ouverture. On évite toute interface métal/diélectrique susceptible de générer une décharge électrostatique.

Une liaison de masse relie le coupon 3 à l'unité de stockage 31.

La figure 6 illustre encore un autre mode de réalisation du dispositif selon l'invention.

L'unité de stockage 31 est réalisée identique à celle du dispositif illustré en figure 6. En revanche, le coupon 3 présente trois rangées de cellules photoélectriques 5 couvertes de plaques de verre 9.

La figure 7 illustre encore un autre mode de réalisation du dispositif de modélisation selon l'invention, comportant une unité de stockage 45 qui est disposée autour du coupon 3 et qui est réalisée souple, de sorte qu'elle présente une surface telle qu'elle tapisse l'intérieure de l'enceinte 11.

On comprend de ce qui précède comment le dispositif selon l'invention modélise un panneau solaire de taille assez conséquente pour se rapprocher au mieux des conditions réelles de génération, de propagation et / ou d'entretien de décharges électrostatiques qui se produisent dans un environnement spatial, afin de les étudier.

Il doit toutefois être compris que l'invention n'est pas limitée aux modes de réalisation décrits précédemment. Par exemple, l'unité de stockage pourrait présenter une feuille métallique dont ma surface ne serait pas totalement recouverte par un matériau diélectrique. De même, le coupon échantillon pourrait ne présenter qu'une seule cellule photoélectrique.

Il est a noter que le coupon pourrait être disposé au bord du simulateur ou dans un coin du simulateur diélectrique, auquel cas on ne serait plus traversant mais à côté. On simule alors préférentiellement une décharge en bord de panneau. Toutefois, une telle décharge pourrait représenter une décharge en milieu de panneau si on double ou quadruple les capacités de stockage du diélectrique.

Par ailleurs, dans le cas de mise en gradient de potentiel par électrons, les tensions appliquées sont semblables à celles que l'on rencontre en vol (exemple Tension satellite -5kV et tension différentielle sur les verres de cellules +2kVolts, mais cela peut varier).

Si le mode de représentativité choisi est identique à celui du vol (c'est-à-dire une irradiation en électrons), il suffit simplement de conserver la même valeur de capacité surfacique en farad rapporté à 1 m$^2$ que celle du cas réel (verres des cellules). Ainsi, la décharge se propageant à la même vitesse libérera la même quantité d'énergie au cours du temps. On sera donc représentatif. Le plus simple est de prendre les mêmes verres, mais cela est généralement onéreux, on se contentera d'un diélectrique de préférence souple de même capacité surfacique.

La formule du calcul de la capacité d'un échantillon diélectrique est la suivante :

$$\text{Capacité en Fd/m}^2 = \text{epsilon\_0. epsilon r. / e}$$

Où :

Epsilon_0 = permittivité du vide,

Epsilon = permittivité relative du matériau,

e = épaisseur du diélectrique (en m),

Si le mode de représentativité choisi est celui d'un essai de mise en gradient de potentiel par neutralisation en plasma, les tensions appliquées sont moindres (on a typiquement de -500V à -1000V). Ainsi, pour conserver la même énergie stockée (E=1/2CV$^2$) il conviendrait d'augmenter la capacité de stockage car la tension diminue, et ce d'autant plus que dans la formule de l'énergie, la tension est au carré. Par exemple en divisant la tension par cinq, il faut multiplier la capacité par vingt-cinq pour avoir la même énergie disponible stockée dans le diélectrique simulateur de décharge.

Ainsi, comme il a été constaté lors d'essais, les vitesses de propagation de décharge sont quasiment les mêmes que dans le cas réel. Il convient de stocker par unité de surface, la même quantité d'énergie. L'énergie libérée au cours de la décharge est donc la même. Comme la tension chute, il convient d'augmenter en proportion (du carré) la capacité. Cela peut se faire en jouant sur la permittivité relative ($\varepsilon$r) et/ou en diminuant l'épaisseur de l'échantillon. Il convient donc d'utiliser des échantillons très minces (de préférence de quelques microns à une dizaine de microns)

Concernant les matériaux permettant de réaliser l'échantillon, tout isolant de faible couche peut être utilisé. De l'oxydation (anodique sulfurique ou chromique pour de l'Aluminium par exemple), de la peinture (tout type de peinture isolante), des diélectriques (les plus minces doivent démarrer à des épaisseurs autour de $10\,\mu$m) et également des isolants minces issus des nanotechnologies (par exemple les dépositions de nanofilms ultra mince afin de réaliser de très fortes capacités, autorisant des études sur des cas extrêmes par réduction de la surface d'échantillon à tester ou des cas où la compensation de l'énergie, suite à l'abaissement de tension, est telle qu'elle nécessite l'utilisation de très fortes capacités).

Enfin, lors d'un essai, s'il est remarqué qu'une vitesse de propagation devient différente sur le matériau de stockage d'énergie de la vitesse attendue dans le cas réel, alors il convient d'adapter les capacités de stockage de manière à tenir compte de la différence de vitesse, de manière à libérer la même quantité d'énergie par unité de temps que celle libérée dans le cas réel, et ce sans sortir du cadre de la présente invention.

## Revendications

1. Dispositif de modélisation (1) de la propagation d'une décharge électrostatique sur un panneau solaire à usage spatial, comprenant
un coupon échantillon (3) dudit panneau comportant au moins une cellule photoélectrique (5), **caractérisé en ce qu'**il comporte une unité de stockage électrostatique (21,24 ;31 ;45) comportant une feuille métallique (21 ;33) recouverte au moins partiellement d'un matériau diélectrique (24 ;35), ladite unité de stockage (21,24 ;31 ;45) présentant une ouverture traversante (23 ;43) dans laquelle est disposé ledit coupon échantillon (3).

2. Dispositif de modélisation selon la revendication 1, **caractérisé en ce que** ledit coupon comporte au moins deux cellules (5) séparées par un interstice (7).

3. Dispositif de modélisation selon la revendication 1 ou 2, **caractérisé en ce que** ladite ouverture (23) est sensiblement de la taille dudit coupon échantillon (3) et **en ce que** ledit coupon (3) est fixé par sa périphérie à ladite unité de stockage au moyen d'un matériau de fixation diélectrique (25).

4. Dispositif selon la revendication 3, **caractérisé en ce que** ledit matériau de fixation diélectrique (25) est un film adhésif de polyimide.

5. Dispositif selon l'une quelconque des revendications 1 à 4, **caractérisé en ce que** ladite feuille métallique (21) est réalisée en alliage d'aluminium.

6. Dispositif selon l'une quelconque des revendications précédentes, **caractérisé en ce que** ledit matériau diélectrique (24) est un polyimide.

7. Dispositif selon la revendication 6, **caractérisé en ce que** ledit matériau diélectrique présente une épaisseur inférieure à $500\,\mu$m.

8. Dispositif selon l'une quelconque des revendications précédentes, **caractérisé en ce que** ladite unité de stockage (45) est souple.

9. Dispositif selon l'une quelconque des revendications 1 à 5, **caractérisé en ce que** ledit matériau diélectrique est constitué de plaques de verre (35) de dimensions identiques à celles desdites cellules (5), lesdites plaques de verre (35) étant disposées côte à côte et régulièrement réparties sur toute la surface de la feuille métallique (33).

10. Dispositif selon l'une quelconque des revendications précédentes, **caractérisé en ce que** la feuille métallique (21 ;33) de ladite unité de stockage (21,24 ;31 ;45) et un support dudit coupon échantillon (3) sont reliés par une liaison de masse (27).

11. Système pour simuler les décharges électrostatiques sur un panneau solaire de grandes dimensions à usage spatial, comprenant un dispositif de modélisation (1) selon l'une quelconque des revendications 1 à 10.

**Patentansprüche**

1. Vorrichtung zur Modellierung (1) der Ausbreitung einer elektrostatischen Entladung auf einem Solarpaneel zur Verwendung im Weltraum, aufweisend eine Abschnitt-Probe (3) des Paneels, welche mindestens eine photoelektrische Zelle (5) aufweist, **gekennzeichnet dadurch, dass** sie eine elektrostatische Speicherungseinheit (21, 24; 31; 45) aufweist, welche ein Metallblatt (21; 33), das zumindest teilweise von einem dielektrischen Material (24; 35) bedeckt ist, aufweist, wobei die Speicherungseinheit (21, 24; 31; 45) eine Durchgangsöffnung (23; 43) aufweist, in welcher die Abschnitt-Probe (3) angeordnet ist.

2. Vorrichtung zur Modellierung gemäß dem Anspruch 1, **gekennzeichnet dadurch, dass** der Abschnitt mindestens zwei Zellen (5), welche durch einen Zwischenraum getrennt sind, aufweist.

3. Vorrichtung zur Modellierung gemäß dem Anspruch 1 oder 2, **gekennzeichnet dadurch, dass** die Öffnung (23) im Wesentlich von der Größe der Abschnitt-Probe (3) ist und dass der Abschnitt (3) durch seinen Umfang an der Speicherungseinheit mittels eines dielektrischen Befestigungsmaterials (25) fixiert ist.

4. Vorrichtung gemäß dem Anspruch 3, **gekennzeichnet dadurch, dass** das dielektrische Befestigungsmaterial (25) ein Klebefilm aus Polyimid ist.

5. Vorrichtung gemäß irgendeinem der Ansprüche 1 bis 4, **gekennzeichnet dadurch, dass** das Metallblatt (21) aus einer Aluminiumlegierung gefertigt ist.

6. Vorrichtung gemäß irgendeinem der vorhergehenden Ansprüche, **gekennzeichnet dadurch, dass** das dielektrische Material (24) ein Polyimid ist.

7. Vorrichtung gemäß Anspruch 6, **gekennzeichnet dadurch, dass** das dielektrische Material eine Dicke kleiner 500 $\mu$m aufweist.

8. Vorrichtung gemäß irgendeinem der vorhergehenden Ansprüche, **gekennzeichnet dadurch, dass** die Speicherungseinheit (45) flexibel ist.

9. Vorrichtung gemäß irgendeinem der Ansprüche 1 bis 5, **gekennzeichnet dadurch, dass** das dielektrische Material aus Glasplatten (35) mit Abmessungen, welche identisch mit denjenigen der Zellen (5) sind, gebildet ist, wobei die Glasplatten (35) nebeneinander angeordnet sind und regelmäßig über die gesamte Fläche des Metallblatts (33) verteilt sind.

10. Vorrichtung gemäß irgendeinem der vorhergehenden Ansprüche, **gekennzeichnet dadurch, dass** das Metallblatt (21; 33) der Speicherungseinheit (21, 24; 31; 45) und ein Halter der Abschnittsprobe (3) mittels einer Masseverbindung (27) verbunden sind.

11. System zum Simulieren der elektrostatischen Entladungen auf einem Solarpaneel großer Abmessungen zur Verwendung im Weltraum, aufweisend eine Vorrichtung zur Modellierung (1) gemäß irgendeinem der Ansprüche 1 bis 10.

**Claims**

1. Modelling device (1) for propagating an electrostatic discharge over a solar panel for use in space, comprising

    - a sample length (3) of said panel which comprises at least one photoelectric cell (5), **characterised in that** it comprises an electrostatic storage unit (21, 24; 31; 45) comprising a metallic foil (21; 33) covered at least partially by a dielectric material (24; 35), said storage unit (21, 24; 31; 45) having a through-opening (23; 43) in which there is disposed said sample length (3).

2. Modelling device according to claim 1, **characterised in that** said length comprises at least two cells (5) separated by an interstice (7).

3. Modelling device according to claim 1 or 2, **characterised in that** said opening (23) is substantially the size of said sample length (3), and **in that** said length (3) is fixed by the periphery thereof to said storage unit by means of a dielectric fixing material (25).

4. Device according to claim 3, **characterised in that** said dielectric fixing material (25) is an adhesive polyimide film.

5. Device according to any of the claims 1 to 4, **characterised in that** said metallic foil (21) is produced in an aluminium alloy.

6. Device according to any of the preceding claims, **characterised in that** said dielectric material (24) is a polyimide.

7. Device according to claim 6, **characterised in that** said dielectric material has a thickness less than 500 $\mu$m.

8. Device according to any of the preceding claims, **characterised in that** said storage unit (45) is flexible.

9. Device according to any of the claims 1 to 5, **characterised in that** said dielectric material consists of glass plates (35) with dimensions identical to those of said cells (5), said glass plates (35) being disposed side by side and distributed regularly over all of the surface of the metallic foil (33).

10. Device according to any of the preceding claims, **characterised in that** the metallic foil (21; 33) of said storage unit (21, 24; 31; 45) and a support of said sample length (3) are connected by an earth connection (27).

11. System for simulating electrostatic discharges over a solar panel with large dimensions for use in space, comprising a modelling device (1) according to any of the claims 1 to 10.

FIG.1

FIG.2

FIG.7

FIG.3

FIG.4

FIG.5

FIG.6

**EP 2 252 900 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0938141 A2

**Littérature non-brevet citée dans la description**

- Charge neutralization via arcing on a large solar array in the GEO plasma environment. *IEEE Transactions on Plasma Science,* Octobre 2006, vol. 34 (5